# EUROPÄISCHE PATENTSCHRIFT

(11) **EP 0 515 968 B1**
(45) Veröffentlichungstag und Bekanntmachung des Hinweises auf die Patenterteilung: **16.08.1995**
(21) Anmeldenummer: 92108497.6
(22) Anmeldetag: 20.05.1992
(51) Int. Cl.: H01S 3/103, H01S 3/098, H01S 3/085, H04B 10/00

(54) **Verfahren zum Betreiben eines Halbleiterlasers als modensynchronisierter Halbleiterlaser**
Method of operating a semiconductor laser as mode synchronized semiconductor laser
Méthode pour commander un laser à semiconducteur comme laser à semiconducteur à modes synchrones

(30) Priorität: 31.05.1991 DE 4117866
(43) Veröffentlichungstag der Anmeldung: 02.12.1992
(73) Patentinhaber: Alcatel SEL Aktiengesellschaft, D-70435 Stuttgart (DE); ALCATEL N.V., NL-1077 XX Amsterdam (NL)
(72) Erfinder: Baums, Dieter, Dr., W-7140 Ludwigsburg (DE); Dütting, Kaspar, W-7000 Stuttgart 31 (DE); Hildebrand, Olaf, Dr., W-7000 Stuttgart 61 (DE); Idler, Wilfried, W-7144 Asperg (DE); Laube, Gert, Dr., W-7000 Stuttgart 40 (DE); Schilling, Michael, W-7000 Stuttgart 31 (DE); Schweizer, Heinz, Dr., W-7000 Stuttgart 31 (DE); Wünstel, Klaus, Dr., W-7141 Schwieberdingen (DE)
(74) Vertreter: Pechhold, Eberhard, Dipl.-Phys.

(56) Entgegenhaltungen:
- 16TH EUROPEAN CONFERENCE ON OPTICAL COMMUNICATION, SEPTEMBER 16-20, 1990 Bd. 1, Amsterdam, The Netherlands, SS. 479-482; W. IDLER et al.: 'High speed integrated interferometric injection laser with 22 nm tuning range'
- APPLIED PHYSICS LETTERS Bd. 57, Nr. 8, 20. August 1990, New York, US, SS. 759-761; M.C. WU et al.: 'Transform-limited 1.4 ps optical pulses from a monolithic colliding-pulse mode-locked quantum well laser'
- PATENT ABSTRACTS OF JAPAN vol. 13, no. 439 (E-827)(3787) 3. Oktober 1989 & JP-A-01 168 086

## Beschreibung

Die Erfindung bezieht sich auf ein Verfahren zum Betreiben eines Halbleiterlasers als modensynchronisierter Halbleiterlaser nach dem Patentanspruch 1.

Ein Halbleiterlaser ist beispielsweise aus Electronics Letters 26 Nr. 4 (1990), S. 243-244 bekannt. Der dort beschriebene Halbleiterlaser ist auf einem n-dotierten Indiumphosphid-Substrat monolithisch integriert. Er weist eine sich oberhalb einer zur Grundfläche des Substrats koplanaren Ebene auf dem Substrat erstreckende und in der Ebene eine verzweigte, einfach zusammenhängende Struktur bildende Kavität auf. Die untere Seite des Substrats wird als Grundfläche bezeichnet. Oberhalb des Indiumphosphid-Substrats erstreckt sich eine ebenfalls n-dotierte Pufferschicht aus Indiumphosphid. Auf deren ebener Oberfläche liegt die Kavität aus Indium-Gallium-Arsenid-Phosphid (InGaAsP). Die Kavität wird als "einfach zusammenhängendes" Gebiet im Sinne der topologischen Definition aufgefaßt, da sie aus einem einzigen Stück mit einem einzigen Rand besteht. In diesem Fall besitzt die Kavität die Form eines "Y". Oberhalb der Kavität sind weitere Schichten vorhanden. Diese bilden zusammen mit ihr oberhalb der Pufferschicht eine "Y"-förmige Mesa, die durch Ätzen herausgeformt wurde.

Außerdem ist auch das Phänomen der Modensynchronisation an sich bekannt. Unter Modensynchronisation wird ein resonanzähnliches Phänomen verstanden, bei dem ein Halbleiterlaser mit einem Wechselstrom einer Frequenz moduliert wird, die dem Kehrwert der Umlaufzeit eines Lichtpulses in dem Halbleiterlaser entspricht. Die aktive Modensynchronisation von Halbleiterlasern ist eine Technik, die die Erzeugung von Lichtpulsen sehr kurzer Dauer erlaubt. Solche Lichtpulse sind von Bedeutung für Nachrichtenübertragungssysteme, die im Gigahertz-Bereich arbeiten. Modensynchronisierte Halbleiterlaser bieten die Möglichkeit, Nachrichten mit Geschwindigkeiten zu übertragen, die merklich über den höchsten Frequenzen liegen, bei denen Halbleiterlaser mit bekannten Techniken direkt moduliert werden können.

Für die Nachrichtenübertragung werden Lichtpulse oder Folgen von Lichtpulsen zeitlich unterschiedlich über Verzögerungsstrecken verzögert, anschließend in Modulatoren moduliert und zu einem Multiplexrahmen zusammengefügt. Die Lichtpulse derartiger Halbleiterlaser lassen sich auch für die Meßtechnik verwenden, insbesondere, wenn Frequenzen oberhalb von 20 GHz gemessen werden sollen. Ebenso dienen solche Halbleiterlaser zur Ansteuerung optischer Korrelatoren für die Adressencodierung von Einzelbits oder zur Codierung von Bitgruppen (Headercodierung).

Aus Appl. Phys. Lett. 57 (1990), Seiten 759 bis 761 ist ein aktiv modensynchronisierter Halbleiterlaser bekannt, der eine einfache, unverzweigte Kavität zur Ausbreitung der in ihm erzeugten Lichtpulse hat. Die Kavität besteht aus Schichten, die abwechselnd aus Indium-Gallium-Arsenid-Phosphid und Indium-Gallium-Arsenid bestehen (d.h. aus einer Quantum-Well-Schichtfolge). Die Kavität ist in fünf Bereiche eingeteilt, zwei an die Resonatorendflächen angrenzende Bereiche als Modulatoren, durch die ein Wechselstrom fließt, ein Bereich in der Mitte der Kavität, der als sättigbarer Absorber dient, und zwei Bereiche zwischen den Modulatoren und dem Absorber als aktive Wellenleiter.

Es ist die Aufgabe der Erfindung, ein Verfahren zum Betreiben eines Halbleiterlasers der eingangs genannten Art als modensynchronisierter Halbleiterlaser zu schaffen, das für die optische Nachrichtenübertragung vielseitig verwendbar ist.

Das Verfahren wie in Anspruch 1 beansprucht erlaubt die Bildung von Lichtpulsen geringer Breite und hoher optischer Leistung. Es können z.B. Lichtpulse in zwei Bereichen der Kavität gleichzeitig erzeugt werden und anschließend in einem weiteren Bereich einander überlagert werden. Andererseits ist es möglich, in zwei Bereichen im Wechsel Lichtpulse zu erzeugen, indem der Wechselstrom dem einen Bereich ohne Phasenverschiebung, dem anderen Bereich mit einer Phasenverschiebung von π zugeführt wird. Dadurch lassen sich in dem angrenzenden Bereich Lichtpulse einer Frequenz erzeugen, die das Doppelte der Frequenz des Wechselstroms beträgt.

Das Verfahren läßt sich vorteilhaft bei einem Halbleiterlaser verwenden, wenn dieser in Verbindung mit einem Multiplexer oder Demultiplexer zur Erzeugung kurzer Lichtpulse eingesetzt wird.

Die Erfindung wird anhand der Zeichnungen in Ausführungsbeispielen erläutert. Es zeigen:
- Fig. 1: einen Halbleiterlaser,
- Fig. 2a: den durch mindestens einen der Bereiche des Halbleiterlasers fließenden Strom als Funktion der Zeit und
- Fig. 2b: die durch den Strom erzeugten Lichtpulse.

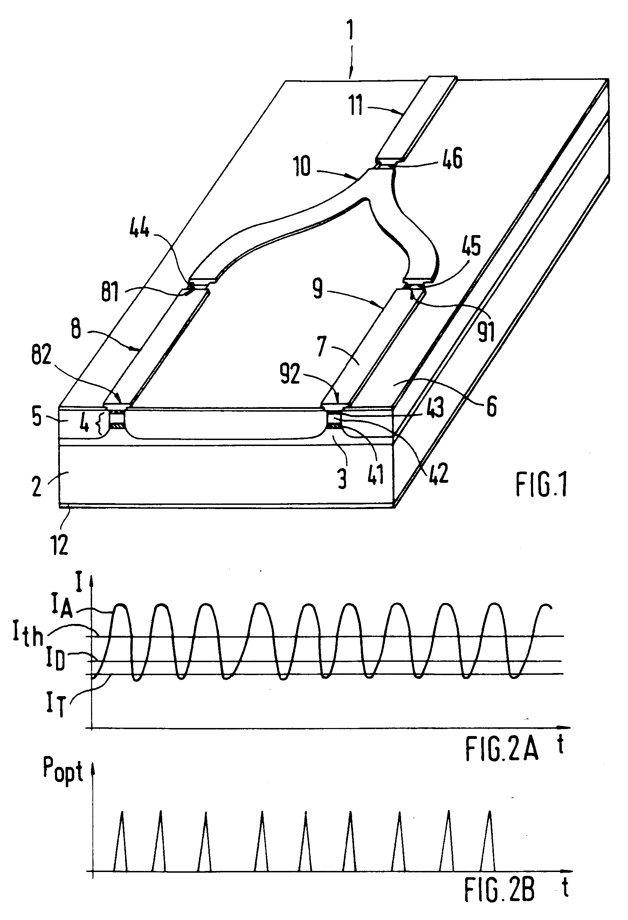

In Fig. 1 ist ein Halbleiterlaser 1 dargestellt. Er weist ein Substrat 2 aus n-dotiertem Indiumphosphid auf. Darüber liegt eine Pufferschicht 3, die ebenfalls aus n-dotiertem Indiumphosphid besteht und von der ein Teil die unterste Schicht einer Mesa 4 bildet, die die Form eines "Y" hat. Die Mesa 4 weist mehrere Schichten auf. Sie enthält eine Kavität 41 aus Indium-Gallium-Arsenid-Phosphid. Diese wird von einer Mantelschicht 42 aus p-dotiertem Indiumphosphid bedeckt. Darüber liegt eine Kontaktschicht 43 aus p⁺-dotiertem Indium-Gallium-Arsenid.

Anstelle der Kavität 41 kann auch eine Quantum-Well-Schichtfolge vorhanden sein, wie sie z.b. aus Appl. Phys. Lett 39 (1981), Seiten 786 bis 788 bekannt ist.

Der Halbleiterlaser 1 kann auch als GaAlAs/GaAs-Halbleiterlaser aufgebaut sein; ein derartiger Aufbau ist z.B. aus Appl. Phys. Lett. 52 (1988), Seiten 767 bis 769 bekannt.

Seitlich der Mesa 4 und oberhalb der nicht durch die Kavität 41 bedeckten Oberfläche der Pufferschicht 3 ist zur elektrischen Isolation eine Schicht 5 aus semiisolierendem Indiumphosphid vorhanden, deren obere Oberfläche mit der oberen Oberfläche der Kontaktschicht 43 eine Ebene bildet. Die Schicht 5 ist mit einer Schutzschicht 6 aus Siliziumdioxid bedeckt, die Kontaktschicht 43 mit einer Metallschicht 7.

In die Metallschicht 7 sind drei Gräben 44, 45, 46 hineingeätzt, durch die sie in vier Bereiche 8, 9, 10 und 11 eingeteilt wird. Gemäß der Darstellung in Fig. 1 können die Gräben 44, 45, 46 auch bis in die Mantelschicht 42, jedoch nicht in die Kavität 41 herabreichen. Durch die Gräben 44-46 ist auch die Mesa 4 in vier Bereiche 8, 9, 10, 11 eingeteilt. Die Bereiche 8 und 9 verlaufen nebeneinander. Sie grenzen jeweils an ihrem einen Ende 81 bzw. 91 an einen verzweigten Bereich 10. Die Metallschicht 7 bildet in jedem Bereich 8-11 je eine erste Elektrode. Eine zweite Elektrode wird für alle Bereiche 8-11 gemeinsam durch eine Metallschicht 12 gebildet, die unterhalb des Substrats 2 aufgebracht ist.

Gemäß einem ersten Ausführungsbeispiel des Verfahrens fließt durch jeden Bereich 8, 9, 10, 11 ein Gleichstrom I_{D}, (Fig. 2) dessen Wert oberhalb der Schwelle liegt, bei der der jeweilige Bereich 8, 9, 10, 11 für Licht der sich in der Kavität 41 ausbreitenden Wellenlänge durchlässig wird. Der dieser Schwelle entsprechende Strom heißt Transparenzstrom I_{T}. Der Gleichstrom I_{D} ist jedoch jeweils kleiner als der Laserschwellstrom Iₜₕ. Die Gleichströme I_{D} in den Bereichen 8-11 sind nicht notwendigerweise gleich, sondern einzeln innerhalb dieser Grenzen frei wählbar. Sie lassen sich auch während des Betriebs des Halbleiterlasers 1 verändern.

Darüber hinaus fließt durch den Bereich 11 ein dem Gleichstrom I_{D} überlagerter Wechselstrom I_{A}. Der Wechselstrom I_{A} ist ein im wesentlichen sinusförmiger Strom mit einer Amplitude, die, zum Gleichstrom I_{D} hinzuaddiert, ausreicht, den Pegel des Laserschwellstroms Iₜₕ in dem Bereich 11 zu übersteigen. Auf diese Weise wird pulsweise Licht kohärent verstärkt. Es entstehen Lichtpulse. Die Frequenz des Wechselstroms I_{A} wird so gewählt, daß sie dem Kehrwert der Umlaufdauer eines jeden Lichtpules zwischen dem Bereich 11, dem Bereich 10 und dem Bereich 8 entspricht. Diese Umlaufdauer entspricht der Umlaufdauer zwischen Bereich 11, dem Bereich 10 und dem Bereich 9. Die Frequenz des Wechselstromes I_{A} kann auch ein ganzzahliges Vielfaches dieser Frequenz sein.

Vorteilhaft ist es, wenn die in dem Bereich 11 erzeugten Lichtpulse nach Durchlaufen des Bereiches 10 und des Bereiches 8 oder nach Durchlaufen des Bereiches 10 und des Bereiches 9 noch jeweils einen weiteren Bereich durchlaufen, der sich an das jeweils andere Ende 82, 92 der Bereiche 8 und 9 anschließt (in Fig. 1 nicht dargestellt) und der jeweils als sättigbarer Absorber dient. Durch ihn fließt kein Gleichstrom I_{D}. Beispielsweise liegt an ihm eine Spannung in Sperrichtung an. Diese Bereiche dienen jeweils zur Verschmälerung der Lichtpulse. Sie können aber auch so angesteuert werden, daß Lichtimpulse abgeschwächt oder auch ganz unterdrückt werden. Es ergibt sich damit die Möglichkeit, eine Folge von Lichtimpulsen entsprechend einem vorgegebenen Signal zu modulieren.

In einem zweiten Ausführungsbeispiel fließt wieder durch die Bereiche 8, 9 und 10 ein Gleichstrom I_{D}; ein Wechselstrom I_{A} fließt jeweils durch die Bereiche 8 und 9, so daß in ihnen beim Überschreiten des Laserschwellstromes Iₜₕ jeweils phasengleich Lichtpulse erzeugt werden. Die in den Bereichen 8 und 9 erzeugten Lichtpulse fallen in dem an den Bereich 11 angrenzenden Teil des Bereichs 10 zusammen. Dadurch lassen sich in dem Halbleiterlaser 1 Lichtpulse mit einer Verstärkung erzeugen, die oberhalb der Verstärkung liegt, die maximal in jedem der Bereiche 8, 9 einzeln erzeugbar ist. Der Bereich 11 dient als sättigbarer Absorber.

Somit werden aus dem Bereich 11 Lichtpulse aus dem Halbleiterlaser 1 ausgestrahlt, die gegenüber denjenigen Lichtpulsen, die jeweils aus den Bereichen 8 und 9 aus dem Halbleiterlaser ausgestrahlt werden könnten, eine größere Amplitude haben. Die Amplitude ist z.B. bis zu 30 % größer.

In einem dritten Ausführungsbeispiel werden die Lichtpulse in den Bereichen 8 und 9 im Gegentakt, d.h. im Unterschied zu dem vorherigen Ausführungsbeispiel nicht phasengleich, sondern mit einem Phasenversatz π erzeugt, indem der Wechselstrom I_{A}, der durch den Bereich 8 fließt, den Phasenversatz π gegenüber dem Wechselstrom I_{A} hat, der durch den Bereich 9 fließt. Dieses Verfahren ermöglicht die gleichzeitige Ausstrahlung von Lichtpulsen, deren Wiederholfrequenz der einfachen Frequenz oder der doppelten Frequenz des Wechselstroms I_{A} entspricht: Die Lichtpulse der einfachen Wiederholfrequenz werden abwechselnd aus den Bereichen 8 und 9 aus dem Halbleiterlaser 1 ausgestrahlt, die Lichtpulse der doppelten Wiederholfrequenz aus dem Bereich 11.

Bei den bisher beschriebenen Ausführungsbeispielen hat die Kavität 41 in allen Bereichen 8-11 beispielsweise eine Zusammensetzung von In_{0,62}Ga_{0,38}As_{0,82}P_{0,18}, bei der der Halbleiterlaser 1 Lichtpulse aus dem Wellenlängenbereich um 1520 nm emittiert.

Wenn die Kavität in den Bereichen 8, 9 und 10 gemäß dem ersten Ausführungsbeispiel oder die Kavität 41 in dem Bereich 10 gemäß dem zweiten und dem dritten Ausführungsbeispiel eine Zusammensetzung von z.B. In_{0,57}Ga_{0,43}As_{0,73}P_{0,27} hat, ist sie durchlässig für Lichtpulse einer Wellenlänge aus dem Wellenlängenbereich um 1300 nm, ohne daß diese Lichtpulse stark absorbiert werden. In diesen Fällen bildet die Kavität 41 in den Bereichen 8, 9 und 10 bzw. nur in dem Bereich 10 einen passiven Wellenleiter, durch den kein Gleichstrom I_{D} fließt. Oberhalb der Kavität 41 sind, wenn diese als passiver Wellenleiter dient, entweder die Mantelschicht 42 und die Kontaktschicht 43 vorhanden, oder die Schicht 5 erstreckt sich auch oberhalb der Kavität 41.

In einem vierten Ausführungsbeispiel ist die Kavität 41 ausschließlich in dem Bereich 9 als passiver Wellenleiter ausgebildet, während durch die Bereiche 8, 10 und 11, wie im ersten Ausführungsbeispiel beschrieben, der Gleichstrom I_{D} fließt. Die Lichtpulse werden in dem Bereich 11 durch den Wechselstrom I_{A} erzeugt. Bei diesem Ausführungsbeispiel lassen sich auf einfache Weise Laufzeitunterschiede der Lichtpulse in den Bereichen 8 und 9 erzeugen. Wenn sich die aus ihnen zu dem Bereich 11 zurücklaufenden Lichtpulse in dem Bereich 10 überlagern, bilden sie jeweils einen Lichtpuls, der eine geringere Breite hat als die aus den Bereichen 8 und 9 kommenden Lichtpulse. Der Bereich 9 kann auch den gleichen Schichtaufbau haben wie die Bereiche 8, 10 und 11 und in diesem Fall als sättigbarer Absorber betrieben werden.

## Patentansprüche

1. Verfahren zum Betreiben eines Halbleiterlasers (1) mit einer verzweigten, einfach zusammenhängenden, die Form eines "Y" aufweisenden und sich über mindestens 4 einzeln ansteuerbare Bereiche (8-11) hinweg erstreckenden Kavität (41) als modensynchronisierter Halbleiterlaser, bei dem durch mindestens einen der Bereiche (8-11) außer einem Gleichstrom (I_{D}), der größer als der Transparenzstrom (I_{T}) ist, ein Wechselstrom (I_{A}) fließt, durch dessen Amplitude zusammen mit dem Gleichstrom (I_{D}) der Laserschwellstrom (Iₜₕ) überschritten wird und dessen Frequenz dem Kehrwert der Umlaufdauer von Lichtpulsen in der Kavität (41) entspricht, die durch den Wechselstrom erzeugt werden.

2. Verfahren nach Anspruch 1, bei dem die Frequenz des Wechselstroms (I_{A}) dem Kehrwert eines ganzzahligen Vielfachen der Umlaufdauer der durch den Wechselstrom erzeugten Lichtpulse in der Kavität (41) entspricht.

3. Verfahren nach Anspruch 1 oder 2, bei dem die Kavität des Halbleiterlasers einen ersten (8) und einen zweiten Bereich (9) aufweist, die nebeneinander verlaufen und jeweils an einem Ende (81, 91) an einen verzweigten dritten Bereich (10) angrenzen, der seinerseits an einen vierten Bereich (11) grenzt, und bei dem der dritte Bereich stromlos und der im dritten Bereich befindliche Teil der Kavität für aus dem ersten, dem zweiten und dem vierten Bereich kommende Lichtpulse durchlässig ist.

4. Verfahren nach Anspruch 3, bei dem durch den ersten (8), den zweiten (9), den dritten (10) und den vierten Bereich (11) jeweils verschiedene Gleichströme (I_{D}) fließen.

5. Verfahren nach Anspruch 4, bei dem die Lichtpulse in dem vierten Bereich (11) erzeugt werden.

6. Verfahren nach einem der vorstehenden Ansprüche, bei dem jeweils an ein zweites Ende (82, 92) des ersten (8) und des zweiten Bereichs (9) des Halbleiterlasers (1) ein fünfter und ein sechster Bereich angrenzen, über die sich die Kavität (41) erstreckt und bei dem der fünfte und sechste Bereich sättigbare Absorber bilden.

7. Verfahren zum Betreiben eines Halbleiterlasers (1) nach Anspruch 6, bei dem der fünfte und der sechste Bereich stromlos sind.

8. Verfahren zum Betrieben eines Halbleiterlasers (1) nach Anspruch 6, bei dem an dem fünften und dem sechsten Bereich eine Vorspannung in Sperrichtung anliegt.

9. Verfahren nach Anspruch 1 oder 2, bei dem die Kavität des Halbleiterlasers einen ersten (8) und einen zweiten Bereich (9) aufweist, die nebeneinander verlaufen und jeweils an einem Ende (81, 91) an einen verzweigten dritten Bereich (10) angrenzen, der seinerseits an einen vierten Bereich (11) grenzt und bei dem Gleichströme (I_{D}) durch den ersten (8), den zweiten (9) und den dritten Bereich (10) fließen, der vierte Bereich (11) als sättigbarer Absorber dient und in dem ersten (8) und dem zweiten Bereich (9) durch den Wechselstrom (I_{A}) jeweils phasengleiche oder um einen Phasenwinkel π gegeneinander phasenverschobene Lichtpulse erzeugt werden.

10. Verfahren nach Anspruch 6 oder Anspruch 9, dadurch gekennzeichnet, daß mindestens ein als sättigbarer Absorber betriebener Bereich zur Modulation der Folge der vom Halbleiterlaser erzeugten Lichtpulse verwendet wird.

## Claims

1. Method of operating a semiconductor laser (1) having a branched, simply continuous cavity (41) having the shape of a "Y" and extending over at least four individually drivable regions (8 - 11) as mode-synchronized semiconductor laser, in which method, in addition to a direct current (I_{D}) which is greater than the transparency current (I_{T}), an alternating current (I_{A}) whose amplitude, together with the direct current (I_{D}) exceeds the laser threshold current (Iₜₕ) and whose frequency is equal to the reciprocal of the circulation time of light pulses in the cavity (41), said light pulses being generated by the alternating current, flows through at least one of the regions (8 - 11).

2. Method according to Claim 1, in which the frequency of the alternating current (I_{A}) is equal to the reciprocal of an integral multiple of the circulation time of the light pulses generated by the alternating current in the cavity (41).

3. Method according to Claim 1 or 2, in which the cavity of the semiconductor laser has a first region (8) and a second region (9) which extend alongside one another and in each case adjoin at one end (81, 91) a branched third region (10) which in turn adjoins a fourth region (11), and in which the third region is current-free and that portion of the cavity which is situated in the third region is transparent to light pulses arriving from the first, the second and the fourth region.

4. Method according to Claim 3, in which different direct currents (I_{D}) flow in each case through the first (8), the second (9), the third (10) and the fourth region (11).

5. Method according to Claim 4, in which the light pulses are generated in the fourth region (11).

6. Method according to one of the preceding claims, in which there adjoins in each case at a second end (82, 92) of the first (8) and of the second region (9) of the semiconductor laser (1), a fifth and a sixth region over which the cavity (41) extends and in which the fifth region and the sixth region form saturable absorbers.

7. Method of operating a semiconductor laser (1) according to Claim 6, in which the fifth region and the sixth region are current-free.

8. Method of operating a semiconductor laser (1) according to Claim 6, in which a voltage in the reverse direction is present across the fifth region and the sixth region.

9. Method according to Claim 1 or 2, in which the cavity of the semiconductor laser has a first (8) and a second region (9) which extend alongside one another and which adjoin, in each case at one end (81, 91), a branched third region (10) which in turn adjoins a fourth region (11) and in which direct currents (I_{D}) flow through the first (8), the second (9) and the third region (10), the fourth region (11) serves as saturable absorber and in-phase light pulses or light pulses mutually phase-shifted by a phase angle π are generated in each case in the first (8) and the second region (9) by the alternating current (I_{A}).

10. Method according to Claim 6 or Claim 9, characterized in that at least one region which can be operated as saturable absorber is used to modulate the train of light pulses generated by the semiconductor laser.

## Revendications

1. Procédé destiné à commander un laser à semiconducteur (1) comportant une cavité (41) ramifiée, de cohésion simple, ayant la forme d'un "Y" et s'étendant au-dessus d'au moins quatre zones (8-11) excitables individuellement, comme laser à semi-conducteur à modes synchrones, procédé selon lequel passe au moins dans l'une des zones (8-11), outre un courant continu (I_{D}) supérieur au courant transparent (I_{T}), un courant alternatif (I_{A}) dont l'amplitude conjointement avec le courant continu (I_{D}) permet de franchir un courant seuil (Ith) du laser et dont la fréquence correspond à l'inverse de la durée de révolution d'impulsions de lumière dans la cavité (41), lesquelles sont produites par le courant alternatif.

2. Procédé selon la revendication 1, dans lequel la fréquence du courant alternatif (IA) correspond à la valeur inverse d'un multiple entier de la durée de révolution des impulsions de lumière produites par le courant alternatif dans la cavité (41).

3. Procédé selon la revendication 1 ou 2, dans lequel la cavité du laser à semi-conducteur comporte une première (8) et une deuxième zone (9) qui sont parallèles et sont respectivement contiguës, à une extrémité (81, 91), à une troisième zone ramifiée (10) qui à son tour est contiguë à une quatrième zone (11) et dans lequel la troisième zone est sans courant et la partie de la cavité se trouvant dans la troisième zone est perméable aux impulsions de lumière provenant des première, deuxième et quatrième zones.

4. Procédé selon la revendication 3, dans lequel courants continus (ID) chaque fois différents passent à travers les premières (8), deuxième (9), troisième (10) et quatrième zones (11).

5. Procédé selon la revendication 4, dans lequel les impulsions de lumière sont produites dans la quatrième zone (11).

6. Procédé selon l'une des revendications précédentes, dans lequel sont contiguës à chaque deuxième extrémité (82, 92) de la première (8) et de la deuxième zone (9) du laser à semi-conducteur (1) une cinquième et une sixième zone au-dessus desquelles s'étend la cavité (41), et dans lequel les cinquième et sixième zones forment des absorbeurs saturables.

7. Procédé destiné à commander un laser à semiconducteur (1) suivant la revendication 6, selon lequel les cinquième et sixième zones sont sans courant.

8. Procédé destiné à commander un laser à semiconducteur (1) conforme à la revendication 6, selon lequel une tension initiale est appliquée dans le sens de non-conduction à la cinquième et la sixième zone. qui sont parallèles et sont respectivement contiguës, à une extrémité (81, 91), à une troisième zone ramifiée (10) qui à son tour est contiguë une quatrième zone (11)

9. Procédé selon la revendication 1 ou 2, selon lequel la cavité du laser à semi-conducteur comporte une première (8) et une deuxième zone (9) qui sont parallèles et sont respectivement contiguës, à une extrémité (81,91), à une troisième zone ramifiée, qui à son tour est contigüe à une quatrième zone (11), et dans lequel des courants continus (I_{D}) passent à travers les première (8), deuxième (9) et troisième zones (10), la quatrième zone (11) servant d'absorbeur saturable, et dans lequel sont produites dans la première zone (8) et la deuxième zone (9), par le courant alternatif (IA), des impulsions de lumière en phase ou déphasées les unes par rapport aux autres d'un angle de phase π.

10. Procédé selon la revendication 6 ou la revendication 9, caractérisé en ce qu'au moins une zone commandée en tant qu'absorbeur saturable est utilisée pour moduler la suite d'impulsions de lumière produite par le laser à semi-conducteur.
